# EUROPÄISCHE PATENTSCHRIFT

(11) **EP 3 465 363 B1**
(45) Veröffentlichungstag und Bekanntmachung des Hinweises auf die Patenterteilung: **06.01.2021**
(21) Anmeldenummer: 17725521.3
(22) Anmeldetag: 03.05.2017
(51) Int. Cl.: G05B 19/042, G06F 1/08

(54) **ÜBERPRÜFUNGSVORRICHTUNG**
INSPECTION DEVICE
DISPOSITIF DE CONTRÔLE

(30) Priorität: 30.05.2016 DE 102016006361
(43) Veröffentlichungstag der Anmeldung: 10.04.2019
(73) Patentinhaber: dSPACE digital signal processing and control engineering GmbH, 33102 Paderborn (DE)
(72) Erfinder: KLEMM, Matthias, 33106 Paderborn (DE)
(86) Internationale Anmeldenummer: PCT/EP2017/060502
(87) Internationale Veröffentlichungsnummer: WO 2017/207197

(56) Entgegenhaltungen:
- US-A1- 2006 197 607
- US-A1- 2014 071 982
- Jürgen Gehring ET AL: "A hardware in the loop test bench for the validation of complex ECU Networks", , 7. Juli 2002 (2002-07-07), Seiten 1-19, XP055401072, SAE 2002 World Congress, Detroit, Michigan Gefunden im Internet: URL:https://saemobilus.sae.org/content/200 2-01-0801 [gefunden am 2017-08-24] in der Anmeldung erwähnt

## Beschreibung

Die Erfindung betrifft eine Überprüfungsvorrichtung zum Testen mindestens eines ersten elektronischen Regelungsgerätes.

Häufig umfassen derartige Vorrichtungen zumindest eine erste Recheneinheit und eine räumlich von der ersten Recheneinheit getrennte zweite Recheneinheit, wobei die erste Recheneinheit einen ersten ausführbaren Modellcode zur Berechnung eines ersten Teilmodells des Regelstreckenmodells aufweist und die zweite Recheneinheit einen zweiten ausführbaren Modellcode zur Berechnung eines zweiten Teilmodells des Regelstreckenmodells aufweist.

Aus einem veröffentlichten Produktkatalog "Catalog 2015 / Embedded Success dSPACE", der als gedruckter Katalog erhältlich ist, im weiteren Text unter Angabe der Referenznummer "P1" zitiert wird, und im Internet zu finden ist unter www.dspace.com/de/gmb/home/medien/product_info/catalog_contents.cfm sind Vorrichtungen zum Testen von Regelungsgeräten bekannt. Insbesondere in P1 auf den Seiten 296 bis 331 sowie auf den Seiten 496 bis 515 werden Vorrichtungen und deren Bestandteile für den genannten Anwendungszweck beschrieben. Die Vernetzung der Vorrichtungen ist beispielsweise mittels Ethernet-Schnittstellenkarten, wie bspw. in o.g. Produktkatalog auf den Seiten 472 und 473 realisierbar. Derartige Vorrichtungen können als sogenannte "HIL-Simulatoren" ausgestaltet sein, wobei die Abkürzung "HIL" (engl.: "hardware in the loop") auf einen geschlossenen Regelkreis hinweist.

Die eingangs genannten Regelungsgeräte werden oft als Steuergerät bezeichnet, obwohl deren Funktionsumfang im systemtheoretischen Sinne meist über die "reine" Steuerungsfunktion hinausgeht und Regelungsfunktionen umfasst.

Die erste Recheneinheit der Überprüfungsvorrichtung, die zumindest einen ersten Mikroprozessor aufweist, ist vorgesehen und eingerichtet, um einen ersten Modellcode, der zumindest einen Teil der Regelstreckensimulation realisiert, mittels des Mikroprozessors auszuführen. Der Modellcode bildet zusammen mit der Hardware der Überprüfungsvorrichtung die technische Umgebung eines elektronischen Gerätes oder eines komplexeren technischen Systems zumindest teilweise nach. Mittels des Modellcodes stellt die Überprüfungsvorrichtung beispielsweise simulierte Sensorsignale für das Regelungsgerät bereit. Des Weiteren kann die Überprüfungsvorrichtung beispielsweise als eine gesteuerte Stromsenke für die Ableitung eines von dem Regelungsgerät bereitgestellten Aktor-Stroms dienen.

Die sogenannte HIL-Simulation ist ein internationaler, insbesondere auch im deutschen Sprachraum verwendeter, Fachbegriff für eine Testmethode, bei der ein "eingebettetes System", beispielsweise ein Regelungsgerät oder ein mechatronisches Modul über seine Eingänge und Ausgänge an ein angepasstes Gegenstück, beispielsweise eine als HIL-Simulator ausbildete Überprüfungsvorrichtung, die zur Nachbildung der realen Umgebung des eingebetteten Systems dient, angeschlossen ist. Während des Tests des eingebetteten Systems werden also zumindest ein Teil der Eingangssignale für das eingebettete System von dem HIL-Simulator bereitgestellt und zumindest ein Teil der Ausgangssignale des eingebetteten Systems an den HIL-Simulator gesendet.

Beispielsweise kann mittels eines Modellcodes eines Regelstreckenmodells, der auf der einem HIL-Simulator ausgeführt wird, das zeitliche Verhalten der Umgebung des zu testenden Systems nachgebildet werden. Soll z.B. ein HIL-Simulator ein eingebettetes System, insbesondere ein Regelungsgerät (oft als ECU abgekürzt, engl.: "electronic control unit), testen, dann ist der HIL-Simulator als zumindest teilweise Nachbildung der realen Umgebung des Regelungsgerätes ausgestaltet. Der HIL-Simulator kann also in diesem Fall über seine die Ein- und Ausgänge bzw. bidirektionale Kommunikationskanäle mit dem Steuergerät kommunizieren und somit als angepasstes Gegenstück des Regelungsgerätes fungieren.

Die HIL-Simulation muss meist in Echtzeit ablaufen. Bei der Simulation der technischrelevanten Umgebung des Regelungsgerätes, wobei die simulierte Umgebung die die simulierte Regelstrecke umfasst, können insbesondere solche Interaktionen des Regelungsgerätes, die in einer späteren realen Umgebung des Regelungsgerätes wiederkehren können, automatisiert und/oder in vordefinierter Reihenfolge nachgebildet werden. Dies hat den Vorteil, dass eine neue Entwicklungsversion einer Steuerungs- oder Regelungssoftware unter den gleichen Kriterien getestet werden kann, wie die Vorgängerversion. Somit kann detailliert nachgewiesen werden, ob ein Fehler beseitigt wurde oder nicht (Fehlernachtest, engl. re-testing).

Die Tests an realen Systemen (bspw. an einem Bremssystem oder einem Antischlupfsystem eines Kraftfahrtzeugs) lassen sich mittels der Tests am HIL-Simulator stark verringern und zusätzlich lassen sich Systemgrenzen bzw. Grenzen der Beherrschbarkeit des Regelungsgeräts und/oder der Regelstrecke ermitteln, ohne das reale System und dessen Nutzer (z. B. Automobil und Fahrer) zu gefährden.

Die HIL-Simulation ist immer nur eine Vereinfachung der Realität und kann den später meist folgenden Test am realen System, beispielsweise den Test der Interaktion des Regelungsgerätes mit der "echten" Regelstrecke eines geregelten Prototypen und/oder den Test der Interaktion des Regelungsgerätes mit einem geregelten Serienprodukt, üblicherweise nicht vollständig ersetzen.

Es ist bekannt, eine räumlich verteilte Überprüfungsvorrichtung zum Testen zumindest eines elektronischen Regelungsgerätes zu verwenden, wobei die Überprüfungsvorrichtung zumindest zwei getrennte Recheneinheiten - beispielsweise zumindest zwei beabstandete und vernetzte Simulatoren - umfasst. Bereits in dem im Jahr 2002 veröffentlichten - nachfolgend mit P2 referenzierten - Dokument "A Hardware-in-the-Loop Test Bench for the Validation of Complex ECU Networks", J. Gehring, H. Schütte, dSPACE GmbH, Seite 3, Figur 3 des 2002er Dokuments, Veröffentlichungshinweis "SAE 2002 Word Congress Detroit, Michigan March 4-7, 2002", ist eine als verteilter HIL-Simulator ausgestaltete Überprüfungsvorrichtung dargestellt, die mehrere Recheneinheiten aufweist, die hier beispielsweise als Zentraleinheit also "Central Unit", Motoreinheit also "Engine", Kraftübertragungseinheit also "Transmission" und kombinierte ESP-Federungseinheit also "ESP Suspension" ausgestaltet sind. Die Recheneinheiten sind über ein optisches Verbindungsmittel also ein "High-speed optical link" miteinander vernetzt. Auf Seite 7, rechts, Abschnitt "Conclusion", zweiter Aufzählungspunkt desselben Dokuments wird erwähnt, dass Anforderungen für eine Interprozessor-Kommunikation eine Zeitstempelung und eine automatische Prozess-Synchronisierung erfordern können.

Aus dem - nachfolgend mit P3 referenzierten - Dokument "Hardware-in-the-Loop Technology Enabling Flexible Testing Processes", Andreas Himmler, dSPACE GmbH, Seite 3, Absatz B., Veröffentlichungshinweis "51st AIAA Aerospace Sciences Meeting, 2013, Grapevine, TX, USA" ist bekannt, für HIL-Simulatoren ein auf der physikalischen Schicht des Gigibit-Ethernet aufbauendes serielles Netzwerk namens IOCNET® bereitzustellen, mit dessen Hilfe die für die Eingabe und Ausgabe von Signalen und Daten vorgesehenen Interface-Karten, abgekürzt als I/O-Karten, sowohl untereinander als auch mit der/den Mikroprozessorkarte/n in Echtzeit Daten austauschen können. Für den Datenaustausch zwischen den beispielsweise bis zu 100 Meter entfernten I/O-Karten und/oder herrschbarkeit des Regelungsgeräts und/oder der Regelstrecke ermitteln, ohne das reale System und dessen Nutzer (z. B. Automobil und Fahrer) zu gefährden.

Die HIL-Simulation ist immer nur eine Vereinfachung der Realität und kann den später meist folgenden Test am realen System, beispielsweise den Test der Interaktion des Regelungsgerätes mit der "echten" Regelstrecke eines geregelten Prototypen und/oder den Test der Interaktion des Regelungsgerätes mit einem geregelten Serienprodukt, üblicherweise nicht vollständig ersetzen.

Es ist bekannt, eine räumlich verteilte Überprüfungsvorrichtung zum Testen zumindest eines elektronischen Regelungsgerätes zu verwenden, wobei die Überprüfungsvorrichtung zumindest zwei getrennte Recheneinheiten - beispielsweise zumindest zwei beabstandete und vernetzte Simulatoren - umfasst. Bereits in dem im Jahr 2002 veröffentlichten - nachfolgend mit P2 referenzierten - Dokument "A Hardware-in-the-Loop Test Bench for the Validation of Complex ECU Networks", J. Gehring, H. Schütte, dSPACE GmbH, Seite 3, Figur 3 des 2002er Dokuments, Veröffentlichungshinweis "SAE 2002 Word Congress Detroit, Michigan March 4-7, 2002", ist eine als verteilter HIL-Simulator ausgestaltete Überprüfungsvorrichtung dargestellt, die mehrere Recheneinheiten aufweist, die hier beispielsweise als Zentraleinheit also "Central Unit", Motoreinheit also "Engine", Kraftübertragungseinheit also "Transmission" und kombinierte ESP-Federungseinheit also "ESP Suspension" ausgestaltet sind. Die Recheneinheiten sind über ein optisches Verbindungsmittel also ein "High-speed optical link" miteinander vernetzt. Auf Seite 7, rechts, Abschnitt "Conclusion", zweiter Aufzählungspunkt desselben Dokuments wird erwähnt, dass Anforderungen für eine Interprozessor-Kommunikation eine Zeitstempelung und eine automatische Prozess-Synchronisierung erfordern können.

In einer Offenlegungsschrift einer US-Patentanmeldung mit dem Aktenzeichen US 2006/0197607 A1 wird ein Mess- und Datenerfassungssystem mit einer Echtzeitüberwachungsschaltung zur Implementierung von Regelkreisanwendungen offenbart. Die Systemsteuerschleife könnte die Echtzeitüberwachungsschaltung, eine Datenerfassungsvorrichtung, eine Verarbeitungseinheit und eine Vielzahl von Subsystemen enthalten. Die Subsysteme könnten in der Datenerfassungsvorrichtung enthalten sein oder könnten außerhalb der Datenerfassungsvorrichtung sein. Die Echtzeitüberwachungsschaltung könnte eine Vielzahl von Zeitgebersignalen von der Vielzahl von Teilsystemen empfangen und ein Steuerschleifen-Zeitgebersignal aus der Vielzahl von Zeitgebersignalen auswählen. Die Echtzeitüberwachungsschaltung könnte bestimmen, ob die Operationen des Regelkreises innerhalb eines bestimmten Zeitraums durchgeführt werden, indem sie das Regelkreis-Zeitsteuersignal überwacht und mit der Verarbeitungseinheit kommuniziert. Eine Zeitsignalschnittstelle zur Aufnahme eines Zeitsignals einer globalen Zeitsignalquelle wird in der US-Offenlegungsschrift weder offenbart noch wird die Verwendung des letztgenannten Zeitsignals in irgendeiner Weise angeregt.

Aus dem - nachfolgend mit P3 referenzierten - Dokument "Hardware-in-the-Loop Technology Enabling Flexible Testing Processes", Andreas Himmler, dSPACE GmbH, Seite 3, Absatz B., Veröffentlichungshinweis "51st AIAA Aerospace Sciences Meeting, 2013, Grapevine, TX, USA" ist bekannt, für HIL-Simulatoren ein auf der physikalischen Schicht des Gigibit-Ethernet aufbauendes serielles Netzwerk namens IOCNET® bereitzustellen, mit dessen Hilfe die für die Eingabe und Ausgabe von Signalen und Daten vorgesehenen Interface-Karten, abgekürzt als I/O-Karten, sowohl untereinander als auch mit der/den Mikroprozessorkarte/n in Echtzeit Daten austauschen können. Für den Datenaustausch zwischen den beispielsweise bis zu 100 Meter entfernten I/O-Karten und/oder Prozessorkarten können sogenannte Gigalink-Module zum Einsatz kommen, wie sie beispielsweise im o.g. Dokument P1 auf den Seiten 355 und 361 gezeigt werden. Als Datenübertragungsmedien zwischen den beispielsweise 100 Meter entfernten I/O-Karten und/oder Prozessorkarte/n werden in P3, Seite 3, Absatz B und in P1, Seite 349 eine Glasfaserkabelverbindung, hier als "optical media" oder "fiber-optic cable" bezeichnet, vorgeschlagen. Das bereits genannte Netzwerk IOCNET stellt ein Protokoll bereit, das eine Zeitsynchronisation, insbesondere für das Einlesen von Eingangssignalen an den Schnittstellen der verwendeten I/O-Karten unterstützt; siehe ggf. hierzu Dokument P1, Seite 299 zusammen mit der Abbildung auf derselben Seite.

Die oben genannte Vernetzungs-Lösungen mittels IOCNET® zur Zeitsynchronisierung innerhalb einer Überprüfungsvorrichtung - insbesondere eines HIL-Simulators - zum Testen eines Regelungsgerätes ist allerdings nur vorgesehen für einen Abstand zwischen den Recheneinheiten, der 100 Meter nur unwesentlich überschreitet.

Die Entwicklung von Regelungsgeräten und der darin implementierten Regelungssoftware erfolgt zunehmend in räumlich verteilten Arbeitsgruppen. Hierbei sind häufig mehrere Unternehmen an verschiedenen Standorten beteiligt. Die beteiligten Software- und Hardware-Entwickler benötigen zum Test der Regelungsgeräte in den fortschreitenden Entwicklungsphasen daher häufig angepasste, insbesondere vor Ort anpassbare Überprüfungsvorrichtungen zum Testen.
Es kann somit zukünftig eine Nachfrage nach einer Überprüfungsvorrichtung zum Testen entstehen, die beispielsweise Netzwerk aus zwei oder mehr Recheneinheiten - beispielsweise HIL-Simulatoren - umfasst, wobei sich diese Recheneinheiten bzw. HIL-Simulatoren an unterschiedlichen Standorten befinden, wobei die Standorte einen Abstand von deutlich mehr als 100 Metern aufweisen könnten.

Regelungsgeräte sind in der praktischen Anwendung sehr häufig mit weiteren Regelungsgeräten vernetzt. Beispielsweise sind Kraftfahrzeuge mit mehr als 40 Regelungsgeräten keine Seltenheit, wobei einige der Regelungsgeräte je nach Anwendungsfall nur vernetzt den jeweils zugeordneten Funktionsumfang sicherstellen können, was am Beispiel der Vernetzung eines Automatikgetriebe-Regelungsgerätes mit einem Motor-Regelungsgerät unmittelbar einleuchtend ist.

Sollte ein Bedarf entstehen, Regelungsgeräte an verschiedenen Standorten mit einer verteilten Überprüfungsvorrichtung zum Testen, insbesondere mit einer aus mehreren HIL-Simulatoren bestehenden Überprüfungsvorrichtung, zu verbinden, die beispielsweise mehrere hundert Meter oder mehrere Kilometer voneinander entfernt sind, sich gegebenenfalls sogar auf unterschiedlichen Kontinenten befinden könnten, dann würden bisherige Lösungen einer Vernetzung und Synchronisation der Recheneinheiten der verteilten Überprüfungsvorrichtung unter Umständen - je nach Entfernung der Recheneinheiten der Überprüfungsvorrichtung - versagen, oder es müssten mit den bisherigen Lösungen der Vernetzung und Synchronisation massive Nachteile, insbesondere bezüglich der Genauigkeit der zeitlichen Zuordnung von Interaktionen zwischen den Regelungsgeräten und deren Überprüfungsvorrichtung zum Testen, hingenommen werden.

Ein weiteres Problem bekannter Überprüfungsvorrichtungen ist, das deren elektronische Uhrenschaltungen, meist als "Uhren" abgekürzt, die zur Bereitstellung eines Uhrensignals an weitere Komponenten der Überprüfungsvorrichtung vorgesehen sind, eine Zeitdrift aufweisen.

Vor diesem Hintergrund besteht die Aufgabe der Erfindung darin, eine Überprüfungsvorrichtung anzugeben, die den Stand der Technik weiterbildet.
Ein Vorteil der Erfindung besteht darin, dass eingangs genannte Probleme des Standes der Technik zumindest teilweise ausgeräumt werden.

Die Aufgabe wird sowohl durch eine Überprüfungsvorrichtung zum Testen eines Regelungsgerätes mit den Merkmalen des Patentanspruchs 1 gelöst.

Vorteilhafte Ausgestaltungen der Erfindung sind Gegenstand von abhängigen Patentansprüchen.

Erfindungsgemäß wird eine Überprüfungsvorrichtung 10 zum Testen mindestens eines ersten Regelungsgerätes vorgeschlagen, wobei die Überprüfungsvorrichtung 10 zumindest umfasst: eine erste Recheneinheit Cn1 zur Ausführung eines Modellcodes, wobei mittels des Modellcodes ein simuliertes Regelstreckensignal zur Stimulierung des Regelungsgerätes bereitstellbar ist und ein Aktorsignal des Regelungsgerätes bearbeitbar sind, und eine erste Zeitsignalwandlereinheit 300 aufweisend zumindest
(i) eine erste Zeitsignalschnittstelle G1 zur Aufnahme eines ersten Zeitsignals Ts1 einer globalen Zeitsignalquelle, und (ii) eine Umschaltsignalsendeeinheit 310 , die eingerichtet ist, um ein erstes Umschaltsignal Tr1 zur Weitergabe an einen ersten Multiplexer 164 bereitzustellen, und (iii) eine erste Taktsendeeinheit 312, die eingerichtet ist, um aus dem ersten Zeitsignal Ts1 ein erstes periodisches Taktsignal Tp1 zu erzeugen und das erste periodische Taktsignal Tp1 an eine erste PLL 191 auszugeben, und wobei die Überprüfungseinrichtung 10 des Weiteren umfasst:
(a) einen ersten Oszillator 161 , der eingerichtet ist, um ein zweites periodisches Takt-signals Tp2 zu erzeugen und das zweite periodische Taktsignal Tp2 an eine zweite PLL 192 auszugeben, und
(b) eine erste Uhr 166, die einerseits mittels einer Taktsignalleitung mit dem ersten Mul-tiplexer 164 verbunden ist und andererseits eingerichtet ist, um ein erstes Uhrensignal Tc1 an eine erste Eingabe-Ausgabe-Einheit 171 und/oder die erste Recheneinheit Cn1 weiterzuleiten,
   wobei ein erster Multiplexer-Eingang des ersten Multiplexers 164 mit einem ersten PLL-Ausgang der ersten PLL 191 zur Übertragung eines ersten frequenzstabilisierten Takt-signals Tp11 in Richtung des ersten Multiplexer 164 verbunden ist, und
   wobei ein zweiter Multiplexer-Eingang des ersten Multiplexers 164 mit einem zweiten PLL-Ausgang der zweiten PLL 192 zur Übertragung eines zweiten frequenzstabilisierten Taktsignals Tp22 in Richtung des ersten Multiplexers 164 verbunden ist, und wobei das erste Umschaltsignal Tr1 vorgesehen ist, um damit den ersten Multiplexer 164 derart zu steuern, dass abhängig von einem Zustand des Umschaltsignals Tr1 mittels des ersten Multiplexers 164 entweder das erste frequenzstabilisierte Taktsignals Tp11 oder das zweite frequenzstabilisierten Taktsignals Tp22 an die erste Uhr 166 weiterleitbar ist, und wobei die erste Uhr 166 eingerichtet ist, um abhängig vom Zustand des Umschaltsignals Tr1 entweder das erste frequenzstabilisierte Taktsignals Tp11 oder das zweite frequenzstabilisierte Taktsignals Tp22 zur Erzeugung des ersten Uhrensignals Tc1 zu verarbeiten.

Einer der Vorteile der erfindungsgemäßen Überprüfungsvorrichtung ist es, dass damit die erste Recheneinheit und eine zweite Recheneinheit trotz eines zwischen den Recheneinheiten bestehenden Abstandes von ggf. einigen hundert Metern oder sogar vielen Kilometern auf vergleichsweise einfache Weise zu synchronisieren sind.

Ungewollte Sprünge des sich "normalerweise" in vordefinierten Zeitschritten ändernden ersten Uhrensignals sind mittels der Erfindung reduzierbar oder sogar gänzlich vermeidbar.

Soweit im Rahmen dieses Dokuments der Begriff "Synchronisierung" verwendet wird, ist stets eine zeitliche Synchronisierung gemeint. Eine sogenannte Winkelsynchronisierung baut häufig auf einer zeitlichen Synchronisierung auf. Die Winkelsynchronisierung ist allerdings nicht Gegenstand der vorliegenden Erfindung.

Die Erfindung wird nachfolgend unter Bezugnahme auf die Zeichnung näher erläutert. Hierbei werden gleichartige Teile bzw. Signale mit identischen Bezeichnungen beschriftet. Die dargestellten Ausführungsformen sind stark schematisiert.

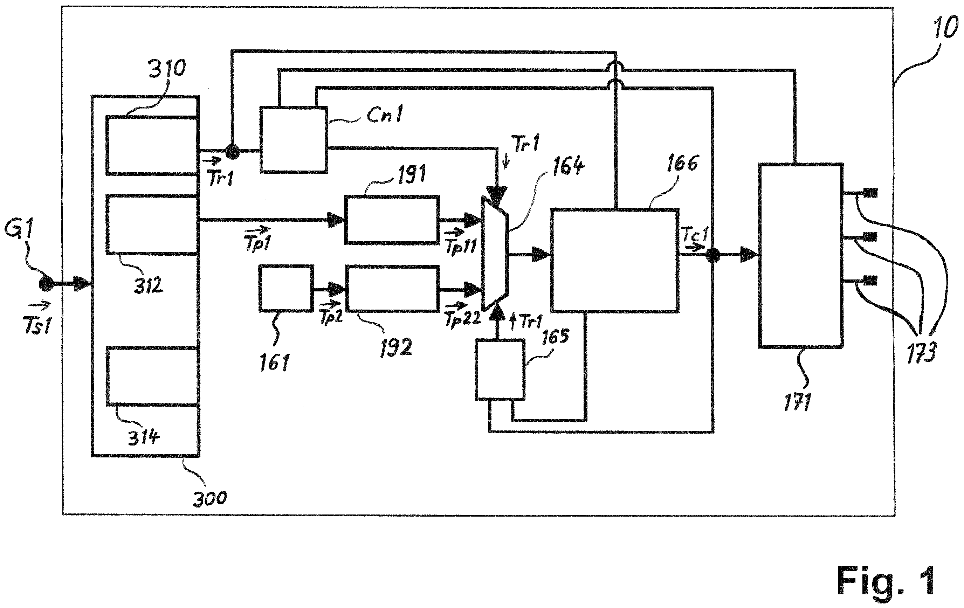

Die Abbildung der Figur 1 zeigt eine schematische Ansicht einer ersten Ausführungsform der erfindungsgemäßen Überprüfungsvorrichtung 10 zum Testen eines Regelungsgerätes, wobei das Regelungsgerät in der Figur 1 nicht dargestellt ist, sondern Eingabe-Ausgabe-Schnittstellen 173, die mit entsprechenden Schnittstellen des Regelungsgerätes während dessen Überprüfung verbunden sind.

In einer erfindungsgemässen Ausführungsform der Überprüfungsvorrichtung 10 sind die erste Recheneinheit Cn1 und/oder die erste Eingabe-Ausgabe-Einheit 171 eingerichtet, um das erste Uhrensignal Tc1 mit berechneten Daten der ersten Recheneinheit Cn1 und/oder mit Daten, die via der Eingabe-Ausgabe-Schnittstellen 173 der ersten Eingabe-Ausgabe-Einheit 171 empfangen wurden, zu verknüpfen.

Gemäß einer weiteren bevorzugten Ausführungsform der Überprüfungsvorrichtung sind die erste Umschaltsignalsendeeinheit 310 und eine Zeitbotschaftssendeeinheit 314 eingerichtet, um bei einem Vorliegen eines vordefinierten und durch eine Zeitbotschaftssendeeinheit 314 bereitgestellten Absolutzeitwertes einen Zustands-wechsel des ersten Umschaltsignals Tr1 vorzunehmen.

In einer bevorzugten Ausführungsform der erfindungsgemäßen Vorrichtung ist die globale Zeitquelle eine Zeitsignalquelle eines globalen Navigationssatellitensystems. Dabei ist es bevorzugt, wenn das globale Navigationssatellitensystem dem Globalen Positionsbestimmungs-System (GPS) oder dem GLONASS- oder dem GALLILEO- oder dem BEIDOU- oder dem GAGAN- oder dem IRNSS- oder dem QZSS- Navigationssatellitensystem entspricht.

Die globale Zeitquelle umfasst bevorzugt mehrere Satelliten.

Ergänzend sei erwähnt, dass die bekannten globalen Navigationssatellitensystem primär zur Positionsbestimmung und Navigation auf der Erde und in der Luft dienen, jedoch die Zeitsignale der globalen Navigationssatellitensysteme für weitere Anwendungen verwendbar sind, wie in dem vorliegenden Dokument dargelegt.

Zu den bekanntesten globalen Navigationssatellitensystemen gehören:
- GPS, also das "Global Positioning System" der Vereinigten Staaten von Amerika;
- GLONASS, also das "GLObal NAvigation Satellite System" der Russischen Föderation;
- Galileo der Europäischen Union und
- Beidou der Volksrepublik China.
Der Vollausbau von Beidou und Galileo wird in den kommenden Jahren erwartet.

Die sogenannte GPS-Zeit entstammt dem Zeitsystem der Navigationssatelliten des Global Positioning Systems. Es entspricht - bis auf eine geringe Abweichung von wenigen Sekunden - der internationalen Atomzeit, abgekürzt mit TAI. Gegenüber der Koordinierten Weltzeit, genannt UTC, weicht die GPS-Zeit ebenfalls um einige Sekunden ab.

Im Rahmen der mit GPS übertragenen Nutzdaten erfolgt in einem eigens dafür vorgesehenen Datenfeld eine Übertragung der aktuellen Differenz der GPS-Zeit zur UTC. GPS-Empfänger können durch Subtraktion der entsprechenden Anzahl von Schaltsekunden automatisch die UTC-Uhrzeit anzeigen bzw. zur Verfügung stellen. GPS-Empfänger eignen sich somit für die Verwendung in einer Zeitsignalwandlereinheit 300, weil diese das erste Zeitsignal Ts1 der globalen GPS-Zeitsignalquelle zur weiteren Verwendung für die Überprüfungsvorrichtung verfügbar machen.

## Patentansprüche

1. Überprüfungsvorrichtung (10) zum Testen mindestens eines ersten Regelungsgerätes, wobei die Überprüfungsvorrichtung (10) zumindest umfasst: eine erste Recheneinheit (Cn1) zur Ausführung eines Modellcodes, wobei mittels des Modellcodes ein simuliertes Regelstreckensignal zur Stimulierung des Regelungsgerätes bereitstellbar ist und ein Aktorsignal des Regelungsgerätes bearbeitbar sind, und eine erste Zeitsignalwandlereinheit (300) aufweisend zumindest
(i) eine erste Zeitsignalschnittstelle (G1) zur Aufnahme eines ersten Zeitsignals (Ts1) einer globalen Zeitsignalquelle, und (ii) eine Umschaltsignalsendeeinheit (310), die eingerichtet ist, um ein erstes Umschaltsignal (Tr1) zur Weitergabe an einen von der Überprüfungsvorrichtung (10) umfassten ersten Multiplexer (164) bereitzustellen, und (iii) eine erste Taktsendeeinheit (312), die eingerichtet ist, um aus dem ersten Zeitsignal (Ts1) ein erstes periodisches Taktsignal (Tp1) zu erzeugen und das erste periodische Taktsignal (Tp1) an eine von der Überprüfungsvorrichtung (10) umfasste erste PLL (191) auszugeben, und wobei die Überprüfungseinrichtung (10) des Weiteren umfasst:
(a) einen ersten Oszillator (161), der eingerichtet ist, um ein zweites periodisches Taktsignals (Tp2) zu erzeugen und das zweite periodische Taktsignal (Tp2) an eine von der Überprüfungsvorrichtung (10) umfasste zweite PLL (192) auszugeben, und
(b) eine erste Uhr (166), die einerseits mittels einer Taktsignalleitung mit dem ersten Multiplexer (164) verbunden ist und andererseits eingerichtet ist, um ein erstes Uhrensignal (Tc1) an eine erste Eingabe-Ausgabe-Einheit (171) und/oder die erste Recheneinheit (Cn1) weiterzuleiten,
wobei ein erster Multiplexer-Eingang des ersten Multiplexers (164) mit einem ersten PLL-Ausgang der ersten PLL (191) zur Übertragung eines ersten frequenzstabilisierten Taktsignals (Tp11) in Richtung des ersten Multiplexer (164) verbunden ist, und
wobei ein zweiter Multiplexer-Eingang des ersten Multiplexers (164) mit einem zweiten PLL-Ausgang der zweiten PLL (192) zur Übertragung eines zweiten frequenzstabilisierten Taktsignals (Tp22) in Richtung des ersten Multiplexers (164) verbunden ist, und wobei das erste Umschaltsignal (Tr1) vorgesehen ist, um damit den ersten Multiplexer (164) derart zu steuern, dass abhängig von einem Zustand des Umschaltsignals (Tr1) mittels des ersten Multiplexers (164) entweder das erste frequenzstabilisierte Taktsignals (Tp11) oder das zweite frequenzstabilisierten Taktsignals (Tp22) an die erste Uhr (166) weiterleitbar ist, und wobei die erste Uhr (166) eingerichtet ist, um abhängig vom Zustand des Umschaltsignals (Tr1) entweder das erste frequenzstabilisierte Taktsinals (Tp11) oder das zweite frequenzstabilisierte Taktsignals (Tp22) zur Erzeugung des ersten Uhrensignals (Tc1) zu verarbeiten, wobei die erste Recheneinheit (Cn1) und/oder die erste Eingabe-Ausgabe-Einheit (171) eingerichtet sind, um das erste Uhrensignal (Tc1) mit berechneten Daten der ersten Recheneinheit (Cn1) und/oder mit Daten, die via der Eingabe-Ausgabe-Schnittstellen (173) der ersten Eingabe-Ausgabe-Einheit (171) empfangen wurden, zu verknüpfen.

2. Überprüfungsvorrichtung nach Anspruch 1, **dadurch gekennzeichnet, dass** die erste Umschaltsignalsendeeinheit (310) und eine Zeitbotschaftssendeeinheit (314) eingerichtet sind, um bei einem Vorliegen eines vordefinierten und durch eine Zeitbotschaftssendeeinheit (314) bereitgestellten Absolutzeitwertes einen Zustandswechsel des ersten Umschaltsignals (Tr1) vorzunehmen.

## Claims

1. Testing device (10) for testing at least one first control device, wherein the testing device (10) comprises at least: a first computing unit (Cn1) for executing a model code, wherein by means of the model code a simulated controlled system signal for stimulating the control device can be provided and an actuator signal of the control device can be processed, and a first time signal converter unit (300) having at least
(i) a first time signal interface (G1) for receiving a first time signal (Ts1) from a global time signal source, and
(ii) a changeover signal transmission unit (310) arranged to transmit a first changeover signal (Tr1) to a first multiplexers (164), the first multiplexer is enclosed by the testing device (10), and
(iii) a first clock transmission unit (312) arranged to generate a first periodic clock signal (Tp1) from the first time signal (Ts1) and to output the first periodic clock signal (Tp1) to a first PLL (191) comprised by the testing device (10), and wherein the testing device (10) further comprises:
(a) a first oscillator (161) arranged to generate a second periodic clock signal (Tp2) and to output the second periodic clock signal (Tp2) to a second PLL (192), the second PLL (192) is included in the testing device (10); and
(b) a first watch (166) which, on the one hand, is connected to the first multiplexer (164) by means of a clock signal line and, on the other hand, is arranged to forward a first clock signal (Tc1) to a first input/output unit (171) and/or to the first computing unit (Cn1),
wherein a first multiplexer input of the first multiplexer (164) is connected to a first PLL output of the first PLL (191) for transmitting a first frequency stabilized clock signal (Tp11) in the direction of the first multiplexer (164), and
wherein a second multiplexer input of the first multiplexer (164) is connected to a second PLL output of the second PLL (192) for transmitting a second frequency stabilized clock signal (Tp22) in the direction of the first multiplexer (164), and
wherein the first switch-over signal (Tr1) is provided in order to thereby control the first multiplexer (164) in such a way that, depending on a state of the switch-over signal (Tr1), either the first frequency-stabilized clock signal (Tp11) or the second frequency-stabilized clock signal (Tp22) can be forwarded to the first watch (166) by means of the first multiplexer (164), and wherein the first watch (166) is set up, in order to process either the first frequency-stabilized clock signal (Tp11) or the second frequency-stabilized clock signal (Tp22) to generate the first clock signal (Tc1), depending on the state of the changeover signal (Tr1), the first computing unit (Cn1) and/or the first input/output unit (171) being set up to combine the first clock signal (Tc1) with calculated data of the first computing unit (Cn1) and/or with data received via the input/output interfaces (173) of the first input/output unit (171).

2. A testing device according to claim 1, **characterized in that** the first change-over signal sending unit (310) and a time message sending unit (314) are arranged to perform a state change of the first change-over signal (Tr1) in the presence of a predefined absolute time value provided by a time message sending unit (314).

## Revendications

1. dispositif de contrôle (10) pour tester au moins un premier dispositif de commande, le dispositif de contrôle (10) comprenant au moins : une première unité de calcul (Cn1) pour exécuter un code modèle, un signal de système commandé simulé pour stimuler le dispositif de commande pouvant être fourni au moyen du code modèle et un signal d'actionneur du dispositif de commande pouvant être traité, et une première unité de conversion de signal de temps (300) ayant au moins (i) une interface de premier signal de temps (G1) pour recevoir un premier signal de temps (Ts1) d'une source de signal de temps global, et (ii) une unité de transmission de signal de commutation (310) agencée pour transmettre un premier signal de commutation (Tr1) à l'un des un appareil de vérification (10) pour fournir les premiers multiplexeurs (164) ; et
(iii) une première unité de transmission d'horloge (312) agencée pour générer un premier signal d'horloge périodique (Tp1) à partir du premier signal de temps (Ts1) et pour délivrer le premier signal d'horloge périodique (Tp1) à une première PLL (191) comprise par le dispositif de contrôle (10), et dans lequel le dispositif de contrôle (10) comprend en outre:
(a) un premier oscillateur (161) agencé pour générer un deuxième signal d'horloge périodique (Tp2) et pour délivrer le deuxième signal d'horloge périodique (Tp2) à une deuxième PLL (192) incluse dans l'appareil de vérification (10); et
b) une première horloge (166) qui, d'une part, est connectée au premier multiplexeur (164) au moyen d'une ligne de signaux d'horloge et, d'autre part, est agencée pour transmettre un premier signal d'horloge (Tc1) à une première unité d'entrée/sortie (171) et/ou à la première unité arithmétique (Cn1),
dans lequel une première entrée de multiplexeur du premier multiplexeur (164) est connectée à une première sortie de PLL de la première PLL (191) pour transmettre un premier signal d'horloge stabilisé en fréquence (Tp11) en direction du premier multiplexeur (164), et
dans lequel une deuxième entrée de multiplexeur du premier multiplexeur (164) est connectée à une deuxième sortie de PLL de la deuxième PLL (192) pour transmettre un deuxième signal d'horloge stabilisé en fréquence (Tp22) dans la direction du premier multiplexeur (164), et
dans lequel le premier signal de commutation (Tr1) est prévu pour commander ainsi le premier multiplexeur (164) de telle sorte que, en fonction d'un état du signal de commutation (Tr1), soit le premier signal d'horloge stabilisé en fréquence (Tp11), soit le deuxième signal d'horloge stabilisé en fréquence (Tp22) peut être transmis à la première horloge (166) au moyen du premier multiplexeur (164), et dans lequel la première horloge (166) est mise en place, afin de traiter soit le premier signal d'horloge à fréquence stabilisée (Tp11), soit le second signal d'horloge à fréquence stabilisée (Tp22) pour générer le premier signal d'horloge (Tc1), en fonction de l'état du signal de commutation (Tr1), la première unité arithmétique (Cn1) et/ou la première unité d'entrée/sortie (171) étant configurée pour combiner le premier signal d'horloge (Tc1) avec les données calculées de la première unité arithmétique (Cn1) et/ou avec les données reçues par les interfaces d'entrée/sortie (173) de la première unité d'entrée/sortie (171).

2. Dispositif de contrôle selon la revendication 1, **caractérisé en ce que** la première unité d'envoi de signal de commutation (310) et une unité d'envoi de message temporel (314) sont agencées pour effectuer un changement d'état du premier signal de commutation (Tr1) en présence d'une valeur de temps absolue prédéfinie fournie par une unité d'envoi de message temporel (314).
